# EUROPÄISCHE PATENTSCHRIFT

(11) **EP 0 306 694 B1**
(45) Veröffentlichungstag und Bekanntmachung des Hinweises auf die Patenterteilung: **06.10.1993**
(21) Anmeldenummer: 88112266.7
(22) Anmeldetag: 28.07.1988
(51) Int. Cl.: H05K 9/00

(54) **Abschirmvorrichtung für geschirmte Kabinen, Räume, Gehäuse oder dergleichen**
Shielding device for shielded cabins, enclosures, casings or the like
Dispositif de blindage pour cabines, enceintes, boîtiers blindés ou équivalents

(30) Priorität: 11.09.1987 DE 3730646
(43) Veröffentlichungstag der Anmeldung: 15.03.1989
(73) Patentinhaber: SIEMENS AKTIENGESELLSCHAFT, 80333 München (DE)
(72) Erfinder: Schaller, Rudolf, Dipl.-Ing., D-8401 Alteglofsheim (DE)

(56) Entgegenhaltungen:
- DE-A- 2 601 277
- DE-U- 8 205 425
- US-A- 3 885 084
- US-A- 4 496 627
- WESCOM TECHNICAL PAPERS, Band 27, 1983, Sitzungs-Aufnahme 9, Seiten 1-4, Absatz 4, San Francisco, US; J.W. WRIGHT: "Material selectrion for good EMI/RFI gasket design"

## Beschreibung

Die Erfindung betrifft eine Abschirmvorrichtung gemäß dem Oberbegriff des Patentanspruchs.

Zur Sicherstellung der elektromagnetischen Verträglichkeit (EMV) von elektrischen, elektronischen und nachrichtentechnischen Geräten und Anlagen sowie zur Erreichung der Abhörsicherheit (Krypto) ist es wichtig, die Ausbreitung elektrischer, magnetischer und elektromagnetischer Felder in bestimmten Raumbereichen zu verhindern.

Dies kann dadurch realisiert werden, daß die zu schützenden Geräte und Anlagen innerhalb von elektromagnetisch abgeschirmten Kabinen, Räumen oder Gehäusen aufgestellt werden.

Ein Maß für die Abschirmwirkung ist die Schirmdämpfung, die möglichst hoch sein soll.

Abgeschirmte Türen, Tore oder Fensterflügel sowie lösbar, beispielsweise durch Verschraubung, miteinander verbundene Gehäuseteile z. B. bei Kabinen in Modulbauweise müssen über Kontaktvorrichtungen mit der Raumschirmung möglichst gut und hochfrequenzdicht kontaktiert werden.

Bei der hochfrequenzdichten Kontaktierung von Gehäusedeckeln mit dem Gehäuse werden Geflechtdichtungen oder leitfähige elastische Materialien verwendet.

Diese Geflichtdichtungen bzw. Kontaktfedersysteme stellen im allgemeinen den dämpfungsärmsten Bereich der Abschirmung dar.

Es besteht daher ständig die Forderung, diese Kontaktbereiche an den technischen Stand der Raumschirmung anzupassen, um die Abschirmwirkung zu verbessern.

Besonders im Mikrowellenbereich (GHz-Bereich) nimmt die Abschirmwirkung von Kontaktfedersystemen und Geflechtdichtungen stark ab, da sich einerseits die Impedanz dieser Systeme verschlechtert und andererseits eine lückenlose Überdeckung der Kontaktbereiche aus konstruktiven Gründen nicht vollständig möglich ist.

Kontaktvorrichtungen, wie beispielsweise das Messerkontaktsystem oder die Z-Feder, geteilte Feder und Wellfeder sind im Siemens-Datenbuch 1983/84, "EMV-Raumschirmung, Kabinen, Bauteile, Filter" beschrieben.

Die Kontaktfedern sind entweder in einen Federkasten eingelegt oder befinden sich direkt zwischen den zu kontaktierenden Flächen des Türblattes und der Türzarge oder den Profilen der Kabinenmodule.

In jedem Fall kommt es darauf an, einen guten impedanzarmen elektrischen Kontakt zwischen den zu kontaktierenden Flächen oder Gehäuseteilen zu erhalten.

Im Mikrowellenbereich reichen diese Kontaktvorrichtungen jedoch nicht aus, um den steigenden Abschirmanforderungen gerecht zu werden.

Bei Raumabschirmungen wurden bisher für die HF-Dichtigkeit im Mikrowellenbereich als Abschirmung miteinander verlötete oder verschweißte Kupfer- bzw. Stahlbleche eingesetzt.

Bei Kontaktvorrichtungen an geschirmten Türen und Gehäusen wurden mehrere parallel verlaufende und überlappende Federreihen oder Geflechtdichtungen eingesetzt, wobei im allgemeinen nicht zu vermeidende, geringste Toleranzabweichungen oder Oberflächenunebenheiten sofort zu Undichtigkeiten führen.

Aufgabe der Erfindung ist es, die eingangs angeführte Abschirmvorrichtung derart weiterzubilden, daß auch im Mikrowellenbereich eine zuverlässig wirkende Schirmdämpfung erreicht wird.

Diese Aufgabe wird erfindungsgemäß mit den kennzeichnenden Merkmalen des Patentanspruchs gelöst.

Durch die Erfindung wird der Vorteil erzielt, daß Mikrowellen, die sich in Hohlräumen (Hohlleiter) - wie sie z.B. bei Kontaktvorrichtungen vorhanden sind - ausbreiten und durch Federschlitze, besonders an Stoßstellen oder im Eckenbereich von geschirmten Kabinen, Türen oder Gehäusedeckeln in den abgeschirmten Raum eindringen können, in sicherer Weise bedämpft bzw. absorbiert werden.

Das vorgeschlagene Absorbermaterial ist ein dämpfendes Medium mit hoher Einfügungsdämpfung und z.B. unter dem Handelsnamen Eccosorb LS 30 der Fa. Emerson & Cuming, Westerloo (Belgien) erhältlich.

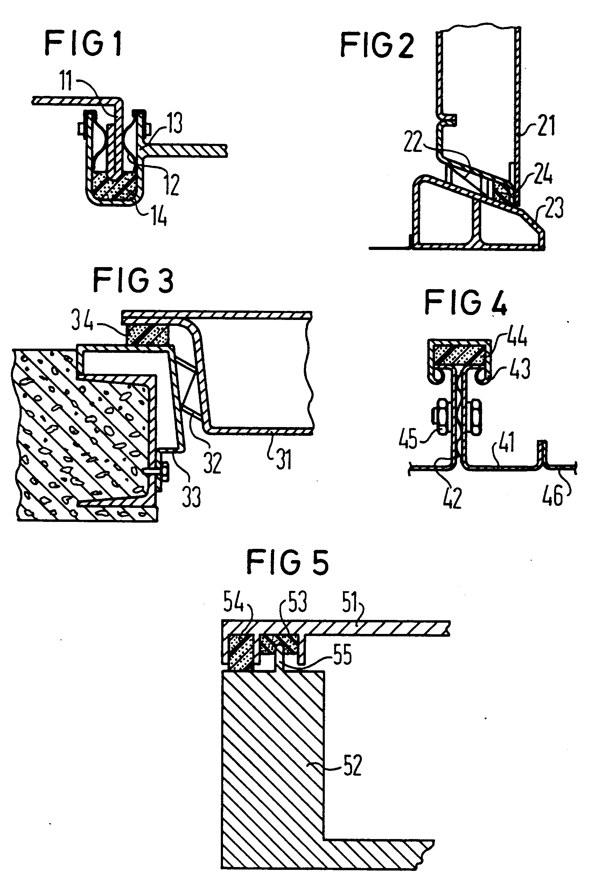

Die Erfindung wird anhand der in der Zeichnung mit den Figuren 1 bis 5 dargestellten unterschiedlichen Ausführungsbeispiele näher erläutert.

In der FIG 1 ist der Federkasten 13 eines Türblattes dargestellt, in den das Messer 11 der Türzarge eingreift. Als erste Kontaktvorrichtung sind Fingerfeder-Streifen 12 vorgesehen, die am Messer 11 der Türzarge anliegen. Der Hohlraum im Federkasten 13 unterhalb der Fingerfeder-Streifen 12 ist mit Absorbermaterial 14 derart ausgefüllt, daß das Messer 11 der Türzarge in den Schaumstoff des Absorbermaterials 14 eingedrückt wird. Durch diese Ausführung ist gewährleistet, daß das Absorbermaterial 14 unter leichtem Anpreßdruck die abzudichtenden Hohlräume spalt- und lückenlos ausfüllt.

In der FIG 2 ist ein weiteres Ausführungsbeispiel dargestellt, das eine Abschirmvorrichtung zwischen Türblatt 21 und Türzarge (Schwelle) 23 zeigt. Eine erste Kontaktvorrichtung besteht aus einer Kontaktfeder (Z-Feder) 22. Das Absorbermaterial 24 ist in einem Hohlraum des Türblattes 21 derart angeordnet, daß ein leichter Anpreßdruck die spalt- und lückenlose Ausfüllung des Hohlraumes gewährleistet.

In der FIG 3 ist eine weitere Abschirmvorrichtung zwischen einer Türzarge 33 und einem Türblatt 31 dargestellt, bei der als erste Kontaktvorrichtung ebenfalls eine Kontaktfeder 32 angeordnet ist. Das Absorbermaterial 34 ist in einem Hohlraum zwischen Türzarge 33 und Türblatt 31 derart angeordnet, daß beim Schließen der Tür ein Anpreßdruck gewährleistet wird, so daß eine sichere Schirmwirkung im Mikrowellenbereich erreicht wird.

In der FIG 4 ist ein durch eine Kontaktschraube 45 verschraubtes Kabinen-Profil 41 dargestellt. Der Zwischenraum zwischen den Füllblechen 46 ist mit einer Kontaktfeder (Wellfeder) 42 abgeschirmt. Ein in der Halteleiste 43 angeordneter Hohlraum ist mit Absorbermaterial 44 ausgefüllt.

In der FIG 5 ist die Abschirmung eines durch einen Gehäusedeckel 51 verschlossenen Gehäuses 52 mit Messerkontakt 55, dargestellt. Der Messerkontakt 55 greift in eine Dichtung 53 ein, die entweder eine Geflechtdichtung ist oder aus einer leitenden Gummidichtung besteht.

Ein weiterer Hohlraum ist durch Absorbermaterial 54 ausgefüllt.

Die in den Figuren dargestellten Ausführungsbeispiele gewähren somit sowohl im Mikrowellen-Bereich bis mindestens 35 GHz als auch bei niedrigeren Frequenzen eine sichere Abschirmung, da das erfindungsgemäß angeordnete Absorbermaterial mit zumindest einem weiteren bei niedrigeren Frequenzen wirksamen Kontaktsystem, wie z.B. einem Federsystem, einem Dichtungsgeflecht oder einer leitenden Gummi- bzw. Kunststoffdichtung kombiniert ist.

Die in den Figuren 1 bis 5 dargestellten Ausführungsbeispiele verbessern beispielsweise bei Frequenzen bis 18 GHz die Schirmdämpfung der bekannten Kontaktvorrichtungen bis zu mehr als 110 dB.

## Patentansprüche

1. Abschirmvorrichtung für geschirmte Kabinen, Räume oder Gehäuse mit HF-dicht geschirmten, gegeneinander beweglichen oder miteinander verbundenen, z. B. verschraubten Gehäuseteilen, insbesondere Türzargen, Türblättern, Fensterflügeln, Fensterrahmen oder Kabinenprofilen, die in ihrem im Randbereich der Gehäuseteile angeordneten Kontaktbereichen durch zumindest ein Kontaktsystem geschirmt sind, **dadurch gekennzeichnet,** daß im Randbereich der Gehäuseteile angeordnete Hohlräume zumindest teilweise mit einem Absorbermaterial (14, 24, 34, 44, 54) im wesentlichen spalt- und lückenlos ausgefüllt sind, und daß das Absorbermaterial (14, 24, 34, 44, 54) aus einem Schaumstoff besteht, der mit leitendem verlustbehaftetem Material auf der Basis von Kohlenstoff getränkt ist.

## Claims

1. Screening device for screened cabins, rooms or housings having housing parts which are screened in an RF-proof manner, can move with respect to one another or are connected, for example screwed, to one another, preferably door frames, door leaves, window leaves, window frames or cabin profiles which are screened by means of at least one contact system in their contact regions which are arranged in the edge region of the housing parts, characterised in that cavities which are arranged in the edge region of the housing parts are at least partially filled with an absorber material (14, 24, 34, 44, 54), essentially without any gaps and spaces, and in that the absorber material (14, 24, 34, 44, 54) is composed of a foam material which is impregnated with conductive, lossy material, based on carbon.

## Revendications

1. Dispositif de blindage pour cabines, enceintes, boîtiers blindés ou analogue, comprenant des parties d'enveloppe étanches aux hautes fréquences, mobiles les unes par rapport aux autres ou reliées entre elles, par exemple vissées, notamment des châssis de portes, des vantails de portes, des battants de croisée, des dormants de fenêtre ou des profilés de cabines dont les zones de contact disposées dans la région marginale des parties d'enveloppe sont blindées par au moins un système de contact, caractérisé en ce que des cavités, ménagées dans la région marginale des parties d'enveloppe, sont emplies sensiblement sans interruption ni lacune, au moins en partie d'une matière absorbante (14, 24, 34, 44, 54) et en ce que la matière absorbante (14, 24, 34, 44, 54) est constituée d'une mousse imprégnée d'une matière à base de carbone présentant une perte de conductivité.
